# EUROPÄISCHE PATENTSCHRIFT

(11) **EP 1 920 472 B1**
(45) Veröffentlichungstag und Bekanntmachung des Hinweises auf die Patenterteilung: **05.08.2009**
(21) Anmeldenummer: 07726174.1
(22) Anmeldetag: 28.06.2007
(51) Int. Cl.: H01L 39/24, C23C 18/44

(54) **VERFAHREN ZUM AUFBRINGEN EINER METALLISCHEN DECKSCHICHT AUF EINEN HOCHTEMPERATURSUPRALEITER**
METHOD FOR APPLYING A METALLIC COVERING LAYER TO A HIGH-TEMPERATURE SUPERCONDUCTOR
PROCÉDÉ POUR APPLIQUER UNE COUCHE MÉTALLIQUE DE RECOUVREMENT SUR UN SUPRACONDUCTUER À HAUTE TEMPÉRATURE

(30) Priorität: 29.06.2006 DE 102006029947
(43) Veröffentlichungstag der Anmeldung: 14.05.2008
(73) Patentinhaber: Zenergy Power GmbH, 53359 Rheinbach (DE)
(72) Erfinder: BÄCKER, Michael, 50670 Köln (DE)
(74) Vertreter: Prietsch, Reiner
(86) Internationale Anmeldenummer: PCT/EP2007/005747
(87) Internationale Veröffentlichungsnummer: WO 2008/000485

(56) Entgegenhaltungen:
- WO-A-02/28527
- WO-A2-01/08233
- US-A- 3 035 944
- US-A- 3 589 916
- US-A- 5 085 693
- US-A- 5 747 178

## Beschreibung

Die Erfindung betrifft ein Verfahren zur Herstellung eines bandförmigen Hochtemperatursupraleiters (HTSL) aus einem Substrat auf das eine zur Hochtemperatursupraleitung bestimmte Schicht und auf diese eine Metallschicht aufgebracht wird.

Bandförmige HTSL bestehen aus einem zumeist metallischen Substrat, einer Pufferschicht und einer auf die Pufferschicht aufgebrachten HTSL-Schicht. Die HTSL-Schicht ist ein Kupratsupraleiter, zumeist aus Seltenerd-Barium-KupferOxid, beispielsweise Yttrium-Barium-Kupferoxid (YBCO). Aus der WO 01/08233 ist bekannt zwei solche Bandleiter zu einem sogenannten Neutralfaserleiter zusammenzufügen. Dazu wird auf die HTSL-Schicht jeweils eine dünne Deckschicht aus einem Metall aufgebracht. Anschließend werden die beiden Deckschichten miteinander verlötet. Die Deckschicht dient zur Passivierung der HTSL-Schicht und als Haftgrund.

Auch ist bekannt auf eine metallische Deckschicht zusätzliche metallische Schichten, z.B. Kupfer zu galvanisieren. Vor dem Galvanisieren muss eine metallische Deckschicht auf die HTSL-Schicht aufgebracht werden, weil diese sonst an der elektrochemischen Reaktion teilnehmen würde. Nimmt die HTSL-Schicht an der elektrochemischen Reaktion teil, wird die Stromtragfähigkeit der HTSL-Schicht verringert.

Solche metallischen Deckschichten werden durch physikalische Verfahren, beispielsweise Sputtern, erzeugt. Diese Verfahren finden unter Vakuum statt und erfordern einen hohen apparativen Aufwand.

Der Erfindung liegt die Aufgabe zugrunde, ein Verfahren zum Herstellen eines bandförmigen HTSL mit einer Deckschicht bereitzustellen, das kostengünstiger als entsprechende physikalische Verfahren ist.

Diese Aufgabe wird durch naßchemisches Aufbringen der metallischen Deckschicht gelöst. Dazu wird zunächst eine metallorganische oder eine anorganische Metallsalz-Lösung auf eine zur Hochtemperatursupraleitung bestimmte Schicht aufgetragen. Anschließend werden das in der Lösung enthaltene Metall oder die enthaltenen Metalle auf die HTSL-Schicht abgeschieden, im Fall der Verwendung einer metallorganischen Salzlösung durch Erwärmung der Lösung, im Fall der Verwendung einer anorganischen Metallsalz-Lösung durch Auftragen einer reduzierende Lösung und anschließendes Erwärmen der aufgetragenen Lösungen. Durch den letztgenannten Schritt wird die Bildung der Metallschicht beschleunigt. In beiden Fällen werden die nach dem Erzeugen der Metall-schicht auf dieser verbliebenen Reste der Metallsalzlösung, d.h. die Lösungsmittel und die Reste der Liganden des jeweils verwandten Metallsalzes durch die Wärmeanwendung von der Metallschicht entfernt, z.B. durch Zersetzen, insbesondere Pyrolisieren und/oder Verdampfen.

Die zur Hochtemperatursupraleitung bestimmte Schicht kann ein fertiger HTSL wie z.B. YBa2Cu3O6.6 oder auch eine sogenannte HTSL-Precursorschicht aus einem noch nicht dotierten "HTSL", wie z.B. YBa2Cu3O6, sein.

Aus der US 4 971 944 ist ein HTSL-Gold-Verbundkörper bekannt, der durch Verpressen zuvor mit Gold beschichteter HTSL-Partikel erzeugt wird. Dazu wird zunächst eine Suspension einer AuCl3-Lösung und HTSL-Partikeln hergestellt. Anschließend wird durch Anwendung von Wärme und optionaler Zugabe eines Reduktionsmittels eine Goldschicht auf den HTSL-Partikeln erzeugt. Das Verfahren hat sich jedoch als unpraktikabel herausgestellt, weil alle Reaktionsprodukte durch Filtrieren entfernt werden müssen. Dies ist bei bandförmigen HTSL nicht möglich. Zudem muss darauf geachtet werden, dass die verwendeten Lösungsmittel absolut wasserfrei sind, denn ansonsten bildet sich Salzsäure, welche den Kuprat-HTSL angreift. Selbst wenn man dies beachtet, führt ein späterer Kontakt mit in der Luft enthaltenem Wasserdampf unvermeidbar zur Bildung von Salzsäure, weil bei der Filtration immer Cl-haltige Reaktionsprodukte auf den HTSL-Partikeln zurückbleiben. Bei der Durchführung des Verfahrens nach der Erfindung bleiben jedoch keine den HTSL angreifenden Rückstände auf dem bandförmigen HTSL zurück.

Vorzugsweise enthalten die verwendeten Metallsalze Edelmetall-Ionen, beispielsweise Silber- und/oder Gold- und/oder Platin-Ionen. Die so abgeschiedene Metall-Schicht ist besonders inert gegen Umwelteinflüsse und greift die HTSL-Schicht nicht an.

Bevorzugt werden der Metallsalz-Lösung nanoskalige Metallpartikel zugegeben. Nanoskalige Metallpartikel haben einen mittleren größten Durchmesser kleiner etwa 120 nm. Im Fall der Verwendung einer anorganischen Metallsalz-Lösung können die nanoskaligen Metallpartikel auch der reduzierenden Lösung zugegeben werden. Durch die nanoskaligen Metallpartikel wird die Dicke der Deckschicht erhöht.

Vorzugsweise ist die Metallsalz-Lösung gesättigt. Auch dies erhöht die Dicke der resultierenden Deckschicht. Wird eine metallorganische Salzlösung auf die zur Hochtemperatursupraleitung bestimmte Schicht aufgebracht, so besteht diese vorzugsweise aus Me-(Hexafluoroacetylacetonate)(1,5-Cyclooctadiene) ϑ und/oder Me-Pentafluorpropionat und/oder Me-Beta-Diketonate und/oder Me-Carbonsäuresalz und/oder Me-NR-R und/oder Me-(CR2)n-R und/oder Me-CO-R und/oder Me-COO-R und/oder Me-CONR-R und/oder Me=CR-R, wobei Me für ein Edelmetall, R für organische Reste und n für einen stöchiometrischen Faktor steht.

Wird eine anorganische Metallsalz-Lösung verwendet, kann die Metallsalz-Lösung vorzugsweise Me-Nitrat und/oder Me-Acetat und/oder Me-Citrat und/oder Me-Trifluoracetat und/oder Me-Tartrat und/oder Me-OH enthalten. Die reduzierende Lösung enthält vorzugsweise Formaldehyd und/oder Hydrazin und/oder ein Boran und/oder eine Schwefelverbindung. Einige Metallsalze lassen sich auch durch Harnstoff reduzieren.

Enthält die reduzierende Lösung als Reduktionsmittel lediglich Formaldehyd, so liegt das Verhältnis von Metall zu Formaldehyd vorzugsweise zwischen etwa 1:1 und etwa 5:1.

Enthält die reduzierende Lösung als Reduktionsmittel lediglich Dimethyl-Aminboran, so liegt das Verhältnis von Metall zu Dimethyl-Aminboran vorzugsweise zwischen etwa 1:2 und etwa 1:10.

Einige Metalle wie z.B. Silber sind bei höheren Temperaturen für 02 diffusionsdurchlässig. Wird eine Metallschicht aus einem solchen Metall auf die zur Höchtemperatursupraleitung bestimmte Schicht aufgebracht, so kann die Dotierung zum HTSL mit 02 alternativ auch erst nach dem Aufbringen der Metallschicht erfolgen. Auch ist eine Teildotierung vor und eine Teildotierung nach dem Aufbringen der Metallschicht möglich.

Das Verfahren kann wiederholt werden, um weitere Metallschichten aufzubringen. Unterschiedliche Ausführungsformen des erfindungsgemäßen Verfahrens können miteinander kombiniert werden. Beispielsweise kann zunächst nach Anspruch 1 eine metallorganische Salzlösung auf die supraleitende Schicht aufgetragen werden, welche dann zur Erzeugung einer Metallschicht erwärmt wird und anschließend kann auf die zuvor aufgebrachte metallische Deckschicht nach Anspruch 4 eine anorganische Metallsalz-Lösung, gefolgt von einer reduzierenden Lösung aufgetragen werden. Anschließend werden die Lösungen zur Beschleunigung der Bildung der Metallschicht und zum Abdampfen überschüssiger Lösungsmittel erwärmt.

Ebenso kann eine weitere Metallschicht galvanisch aufgetragen werden.

Nachfolgend wird die Erfindung anhand dreier Ausführungsbeispiele näher beschrieben.

Die zu beschichtenden HTSL-Proben hatten jeweils eine YBCO-Schicht (d ∼ 300 nm) entweder auf einkristallinen Substraten (STO (100)) oder auf gepufferten Metallsubstrat-Bändern. Die YBCO-Schichten wurden nasschemisch hergestellt. Die Herstellung der YBCO-Schichten und der gepufferten Metallsubstrate ist aus DE 10 2004 041 053.4 bzw. DE 10 2004 038 030.9 bekannt. Ebenso können auch nach anderen Verfahren hergestellte YBCO-Schichten wie in den Beispielen beschrieben beschichtet werden.

### Beispiel 1:

Als Beschichtungslösung wurde (1,5-Cyclooctadien)-(hexafluoroacetylacetonat)-silber(I), 99%, Fa. Aldrich, in Toluol für die Spektroskopie, Fa. Merck, mit einer Konzentration von etwa 1,5M verwendet. Die Proben wurden mittels dip-coating mit einer Ziehgeschwindigkeit von etwa 0,4 cm/s und einer Verweilzeit in der Lösung von bis zu 40 s hergestellt. Alternativ wurde mittels der "ink-jet"-Methode, d.h. mit einem nach dem Tintenstrahlprinzip arbeitenden Druckkopf, ca. 1 µl der Lösung auf 1 cm² aufgebracht (möglich sind auch etwa 0,5 bis etwa 10 µl/cm²). Nach jeder Beschichtung wurden die flüchtigen Bestandteile ausgedampft und bei etwa 300°C innerhalb von etwa 2 Minuten pyrolysiert. Die Erstbeschichtung war eine nicht abwischbare Silberschicht auf der HTSL-Schicht. Das Verfahren wurde bis zu dreimal wiederholt. Dadurch entstand ein nahezu dichter, d.h. geschlossener Silberfilm.

Bei einer Variation des Verfahrens wurden in der Beschichtunglösung Ag-Nanopartikel suspendiert. Die Konzentration der Nanopartikel in der Beschichtungssuspension betrug bis zu 5 Gew.%. Ein optimales Beschichtungsergebnis wurde für Konzentrationen von 1 - 2 Gew.% erhalten. Diese Konzentration ergab nach nur einem Beschichtungszyklus eine geschlossene Deckschicht.

Die Variation des Verfahrens wurde sowohl an rechteckigen sogenannten Kurzproben als auch an Bändern getestet. Die Bänder wurden nach der Beschichtung im Durchzugsverfahren elektrolytisch verkupfert. Als Elektrolyt wurde ein schwefelsaurer Kupferelektrolyt verwendet (Kupfersulfat entsprechend 50g/l Cu; Schwefelsäure entsprechend 25ml/l; Salzsäure entsprechend 60mg/l Cl). Die Beschichtung erfolgte bei einer Badtemperatur von 15° bis 40°C, vorzugsweise bei 25°C. Die Stromdichte betrug 0,3 oder 0,5 kA/m². Eine Verweildauer von 5 Minuten im Bad ergab Schichtdicken von 2 bis 10 µm Kupfer. Die Schicht ist dicht, jedoch nicht optimal glatt und glänzend. Durch den Zusatz von Einebnern und Glanzbildnern wie Thioharnstoff, Derivaten der Thiocarbonsäure und/oder Polyglycolverbindungen in Konzentrationen < 0,1% konnte das Beschichtungsergebnis deutlich verbessert werden. So wurde eine 3µm dicke Schicht hergestellt, die trotz der geringen Dicke deutlich glatter und dichter, d.h. "lückenfreier" ist als eine 8µm dicke Kupferschicht, die ohne die genannten Additive hergestellt wurde.

### Beispiel 2

Die Beschichtung erfolgte kontinuierlich an bandförmigen HTSL mit Metallbandsubstrat mittels zweier Druckköpfe, die unmittelbar nacheinander auf die Oberfläche des jeweiligen HTSL nach dem "Ink-Jet"-Verfahren je eine Lösung aufbrachten. Über den ersten Druckkopf wurde 0,1 - 2µl/cm² Silbernitratlösung auf das Substrat aufgebracht. Über den zweiten Druckkopf wurde sofort im Anschluss eine Reduktionslösung enthaltend entweder Formaldehyd (bevorzugtes Verhältnis Ag/Formaldehyd = 2:1, möglich 1:1 bis 5:1)) oder Dimethyl-aminboran ( bevorzugtes Verhältnis Ag/Dimethylaminboran = 1:6, möglich 1:2 bis 1:10) auf den bandförmigen HTSL "gedruckt", wodurch die jeweilige Reduktionslösung auf die zuvor aufgetragene Silbernitratlösung aufbracht wurde. Anschließend wurde das Band in einem kontinuierlichen Durchzugofen zunächst 2 min (möglich sind 0,5 - 4 min) bei einer Temperatur von 60°C (möglich sind 40° - 80°C) und anschließend 5 min (möglich sind 3 - 15 min) bei 150°C (möglich sind 100 - 210°C) getrocknet. Erhalten wird so eine dichte, nicht abwischbare Silberschicht von 0,2 - 3 µm, abhängig von Konzentration und Menge der aufgebrachten Silbernitratlösung. Als optimal hat sich die Verwendung einer gesättigten, nicht angesäuerten Silbernitratlösung herausgestellt.

Zur Verringerung der löslichen Anteile und zur schnelleren Erzielung einer dichten Deckschicht können der als zweites aufgebrachten Lösung, d.h. der Reduktionslösung, Nanopartikel bis zu einer Konzentration von etwa 5 Gew% (optimal etwa 1 Gew%) zugesetzt werden. Getestet wurde Ag und Cu, möglich sind aber auch andere Metalle oder Legierungen, beispielsweise Edelmetalle oder Edelmetalllegierungen.

Als elektrochemische Abschlussbeschichtung wurde zum einen eine Kupferbeschichtung gemäß Beispiel 1 und zum anderen eine Nickelbeschichtung durchgeführt. Die Ergebnisse der Kupferbeschichtung entsprachen denen des ersten Ausführungsbeispieles.

Für die elektrochemische Nickelbeschichtung wurde ein Elektrolyt auf Nickelsulfamatbasis gewählt (Nickelsulfamat entsprechend 100 g/l Ni; Nickelchlorid entsprechend 25 g/l Cl; Borsäure 40 g/l). Der pH-Wert des Elektrolyten wurde mit Borsäure zwischen etwa 3,5 und etwa 4,5 eingestellt. Die Beschichtung erfolgte bei einer Badtemperatur von 60°C. Ein Wert von 65°C sollte nicht überschritten werden. Die Stromdichte lag zwischen etwa 0,5 kA/m² und etwa 2 kA/m². Bei einer Verweildauer von 3 - 5 min im Bad ergaben sich Schichtdicken von 2 bis 30 µm Nickel. Die Homogenität der Schichten kann durch den Zusatz von Netzmitteln (ca. 1 ml/l) verbessert werden. Generell führen geringere Stromstärken < 0,6 kA/m² und längere Verweilzeiten zu härteren und glänzenderen d.h. sehr porenarme Schichten. Als optimal erwies sich eine Stromstärke von 0,5 kA/m² mit einer Verweilzeit von etwa 5 min entsprechend einer Nickelschichtdicke von etwa 5 µm.

### Beispiel 3:

Die Beschichtung erfolgt auf eine Yttrium-Barium-KupferOxid-Schicht, welche bereits kristallisiert, jedoch noch keiner Sauerstoffbeladung unterzogen wurde. Entsprechend ist die YBCO-Schicht noch nicht dotiert und daher antiferromagnetisch. Als Beschichtungslösung wurde (1,5-Cyclooctadien) - (hexafluoroacetyl-acetonato) -silber(1), 99 %, Fa. Aldrich, in Toluol für die Spektroskopie , Fa. Merck, mit einer Konzentration von etwa 1,5M verwendet. Die Proben wurden mittels dip-coating mit einer Ziehgeschwindigkeit von etwa 0,4 cm/s und einer Verweilzeit in der Lösung von bis zu 40s hergestellt. Alternativ wurde mittels einer "ink-jet"-Methode, d.h. mit einem nach dem Tintenstrahlprinzip arbeitenden Druckkopf, ca.1 µl der Lösung auf 1 cm² aufgebracht (möglich sind auch etwa 0,5 bis etwa 10 µl/cm²). Nach jeder Beschichtung wurden die flüchtigen Bestandteile ausgedampft. Die anschließende Pyrolyse erfolgt bei Temperaturen von 500°C innerhalb von 2 h. Mit dieser Pyrolyse erfolgt auch die Sauerstoffbeladung der Yttrium-Barium-Kupfer-Oxid-Schicht. Die Erstbeschichtung war eine nicht abwischbare Silberschicht auf der HTSL-Schicht. Das Verfahren wurde bis zu dreimal wiederholt. Dadurch entstand ein nahezu dichter, d.h. geschlossener Silberfilm.

## Patentansprüche

1. Verfahren zur Herstellung eines bandförmigen Dünnschicht-HTSL, bei dem auf ein bandförmiges Substrat eine zur Hochtemperatursupraleitung bestimmte Schicht und auf diese eine Metallschicht aufgebracht wird, **dadurch gekennzeichnet, dass** die Metallschicht nasschemisch unter Verwendung einer Lösung eines Metallsalzes mit einem Liganden aufgebracht wird, dessen nach Erzeugen der Metallschicht verbleibende Reste durch Wärme von der zur Hochtemperatursupraleitung bestimmten Schicht entfernbar ist.

2. Verfahren nach Anspruch 1, **dadurch gekennzeichnet, dass**
a) auf die zur Hochtemperatursupraleitung bestimmte Schicht mindestens eine Lösung eines metallorganischen Salzes aufgetragen wird und
b) die aufgetragene Lösung zur Erzeugung einer Metallschicht erwärmt wird.

3. Verfahren nach Anspruch 2, **dadurch gekennzeichnet, dass** die Lösung Me-(Hexafluoroacetylacetonate) (1,5-Cyclooctadiene)) und/oder Me-Penta-fluorpropionat und/oder Me-Beta-Diketonate und/oder Me-Carbonsäuresalze und/oder Me-NR-R und/oder Me-(CR2)n-R und/oder Me-CO-R und/oder Me-COO-R und/oder Me-CONR-R und/oder Me=CR-R enthält, wobei Me für ein Edelmetall, R für organische Reste und n für einen stöchiometrischen Faktor steht.

4. Verfahren nach Anspruch 1, **dadurch gekennzeichnet, dass**
a) auf die zur Hochtemperatursupraleitung bestimmte Schicht eine Lösung eines anorganischen Metallsalzes aufgetragen wird,
b) auf die Lösung eine reduzierende Lösung aufgetragen wird und
c) zur Beschleunigung der Bildung der Metallschicht die aufgetragenen Lösungen erwärmt werden.

5. Verfahren nach Anspruch 4, **dadurch gekennzeichnet, dass** die in Schritt a) aufgebrachte Lösung Me-Nitrat und/oder Me-Acetat und/oder Me-Citrat und/oder Me-Tartrat und/oder Me-Trifluoracetat und/oder Me-OH enthält, wobei Me für ein Edelmetall steht.

6. Verfahren nach einem der Ansprüche 4 oder 5, **dadurch gekennzeichnet, dass** die reduzierende Lösung Formaldehyd und/oder Hydrazin und/oder ein Boran und /oder Harnstoff und/oder eine Schwefelverbindung enthält.

7. Verfahren nach Anspruch 6, **dadurch gekennzeichnet, dass** das Verhältnis von Metall zu Formaldehyd zwischen etwa 1:1 und etwa 5:1 ist.

8. Verfahren nach Anspruch 7, **dadurch gekennzeichnet, dass** das Boran Dimethyl-Aminboran ist und dass das Verhältnis von Metall zu Dimethyl-Aminboran zwischen etwa 1:2 und etwa 1:10 ist.

9. Verfahren nach einem der Ansprüche 2 bis 8, **dadurch gekennzeichnet, dass** die zur Hochtemperatursupraleitung bestimmte Schicht und die erzeugte Metallschicht in einer sauerstoffangereicherten Atmosphäre erwärmt werden.

10. Verfahren nach einem der Ansprüche 2 bis 9, **dadurch gekennzeichnet, dass** zumindest Schritt a) mindestens einmal wiederholt wird.

11. Verfahren nach einem der Ansprüche 2 bis 10, **dadurch gekennzeichnet, dass** Schritt b) mindestens einmal wiederholt wird.

12. Verfahren nach einem der Ansprüche 2 bis 11, **dadurch gekennzeichnet, dass** das in Schritt a) verwendete Metallsalz Silber und/oder Gold- und/oder Platinionen enthält.

13. Verfahren nach einem der Ansprüche 2 bis 12, **dadurch gekennzeichnet, dass** mindestens einer der Lösungen nanoskalige Metallpartikel zugegeben werden.

14. Verfahren nach Anspruch 13, **dadurch gekennzeichnet, dass** als nanoskalige Metallpartikel solche aus Silber und/oder Gold und/oder Platin verwendet werden.

15. Verfahren nach einem der Ansprüche 2 bis 14, **dadurch gekennzeichnet, dass** mindestens eine der Lösungen gesättigt ist.

16. Verfahren nach einem der Ansprüche 2 bis 15, **dadurch gekennzeichnet, dass** mindestens eine weitere Metallschicht aufgebracht wird.

17. Verfahren nach Anspruch 16, **dadurch gekennzeichnet, dass** die weitere Metallschicht galvanisch aufgetragen wird.

18. Verfahren nach Anspruch 17, **dadurch gekennzeichnet, dass** bei galvanischer Abscheidung ein Elektrolyt, der Kupfer- und/oder Edelmetall- und/oder Nickel- und/oder Eisen- und/oder Zinn- und/oder Zink- und/oder Phosphorionen enthält, verwendet wird.

19. Verfahren nach einem der Ansprüche 1 bis 18, **dadurch gekennzeichnet, dass** als zur Hochtemperatursupraleitung bestimmte Schicht ein HTSL-Precursor aufgebracht wird.

20. Verfahren nach einem der Ansprüche 1 bis 18**, dadurch gekennzeichnet, dass** die zur Hochtemperatursupraleitung bestimmte Schicht vor dem Aufbringen der Metallschicht mit O₂ dotiert wird.

## Claims

1. A method for producing a strip-type thin-film HTSC, in which a layer determined for high-temperature superconduction is applied to a strip-type substrate and a metal layer is applied onto the same, **characterized in that** the metal layer is applied in a wet-chemical manner by using a solution of a metal salt with a ligand whose residues remaining after the production of the metal layer can be removed by heat from the layer determined for high-temperature superconduction.

2. A method according to claim 1, **characterized in that**
a) at least one solution of a metallo-organic salt is applied to the layer determined for high-temperature superconduction, and
b) the applied solution is heated for producing a metal layer.

3. A method according to claim 2, **characterized in that** the solution contains Me-(hexafluoroacetylacetonate)(1,5-cyclooctadiene) and/or Me-penta-fluoro-propionate and/or Me-beta-diketonate and/or Me-carbonic acid salts and/or Me-NR-R and/or Me-(CR₂)ₙ-R and/or Me-CO-R and/or Me-COO-R and/or Me-CONR-R and/or Me=CR-R, wherein Me is a noble metal, R is an organic residue, and n is a stoichiometric factor.

4. A method according to claim 1, **characterized in that**
a) a solution of an inorganic metal salt is applied to the layer determined for high-temperature superconduction,
b) a reducing solution is applied to the solution, and c)the applied solutions are heated for accelerating the formation of the metal layer.

5. A method according to claim 4, **characterized in that** the solution applied in step a) contains Me-nitrate and/or Meacetate and/or Me-citrate and/or Me-tartrate and/or Metrifluoroacetate and/or Me-OH, wherein Me is a noble metal.

6. A method according to one of the claims 4 or 5, **characterized in that** the reducing solution contains formaldehyde and/or hydrazine and/or a borane and/or urea and/or a sulphur compound.

7. A method according to claim 6, **characterized in that** the ratio of metal to formaldehyde is between approx. 1:1 and approx. 5:1.

8. A method according to claim 7, **characterized in that** the borane is dimethylamine borane and the ratio of metal to dimethylamine borane is between approx. 1:2 and approx. 1:10.

9. A method according to one of the claims 2 to 8, **characterized in that** the layer determined for high-temperature superconduction and the produced metal layer are heated in an oxygen-enriched atmosphere.

10. A method according to one of the claims 2 to 9,
**characterized in that** at least step a) is repeated at least once.

11. A method according to one of the claims 2 to 10,
**characterized in that** step b) is repeated at least once.

12. A method according to one of the claims 2 to 11,
**characterized in that** the metal salt used in step a) contains silver ions and/or gold ions and/or platinum ions.

13. A method according to one of the claims 2 to 12,
**characterized in that** nanoscale metal particles are added to at least one of the solutions.

14. A method according to claim 13, **characterized in that** nanoscale metal particles made of silver and/or gold and/or platinum are used.

15. A method according to one of the claims 2 to 14,
**characterized in that** at least one of the solutions is saturated.

16. A method according to one of the claims 2 to 15,
**characterized in that** at least one further metal layer is applied.

17. A method according to claim 16, **characterized in that** the further metal layer is applied by electroplating.

18. A method according to claim 17, **characterized in that** an electrolyte which contains copper ions and/or noble metal ions and/or nickel ions and/or iron ions and/or tin ions and/or zinc ions and/or phosphorus ions is used in electrolytic deposition.

19. A method according to one of the claims 1 to 18,
**characterized in that** an HTSC precursor is applied as the layer determined for high-temperature superconduction.

20. A method according to one of the claims 1 to 18,
**characterized in that** the layer determined for high-temperature superconduction is doped with O₂ prior to applying the metal layer.

## Revendications

1. Procédé pour la fabrication d'un HTSL en couche mince en forme de bande, dans lequel une couche destinée à être supraconductrice à haute température est appliquée sur un substrat en forme de bande et une couche métallique par-dessus celle-ci, **caractérisé en ce que** la couche métallique est appliquée par une méthode chimique par voie humide en utilisant une solution d'un sel de métal avec un ligand, dont les résidus restant après la création de la couche métallique peuvent être éliminés par la chaleur de la couche destinée à être supraconductrice à haute température.

2. Procédé selon la revendication 1, **caractérisé en ce que**
a) au moins une solution d'un sel organométallique est appliquée sur la couche destinée à être supraconductrice à haute température et
b) la solution appliquée est chauffée pour créer une couche métallique.

3. Procédé selon la revendication 2, **caractérisé en ce que** la solution contient des Me-(hexafluoroacétonate)(1,5-cyclooctadiènes)) et/ou du pentafluoropropionate de Me et/ou des bêta-dicétonates de Me et/ou des sels d'acide carboxylique de Me et/ou Me-NR-R et/ou Me-(CR2)n-R et/ou Me-CO-R et/ou Me-COO-R et/ou Me-CONR-R et/ou Me-CR-R, où Me représente un métal noble, R des radicaux organiques et n un facteur stoechiométrique.

4. Procédé selon la revendication 1, **caractérisé en ce que**
a) une solution d'un sel de métal inorganique est appliquée sur la couche destinée à être supraconductrice à haute température,
b) une solution réductrice est appliquée sur la solution, et
c) les solutions appliquées sont chauffées pour accélérer la formation de la couche métallique.

5. Procédé selon la revendication 4, **caractérisé en ce que** la solution appliquée dans l'étape a) contient un nitrate de Me et/ou un acétate de Me et/ou un citrate de Me et/ou un tartrate de Me et/ou un trifluoroacétate de Me et/ou Me-CH, où Me représente un métal noble.

6. Procédé selon l'une des revendications 4 ou 5, **caractérisé en ce que** la solution réductrice contient du formaldéhyde et/ou de l'hydrazine et/ou un borane et/ou de l'urée et/ou un composé soufré.

7. Procédé selon la revendication 6, **caractérisé en ce que** le rapport entre le métal et le formaldéhyde est compris entre environ 1:1 et environ 5:1.

8. Procédé selon la revendication 7, **caractérisé en ce que** le borane est du diméthylaminoborane et **en ce que** le rapport entre le métal et le diméthylaminoborane est compris entre environ 1:2 et environ 1:10.

9. Procédé selon l'une des revendications 2 à 8, **caractérisé en ce que** la couche destinée à être supraconductrice à haute température et la couche métallique créée sont chauffées dans une atmosphère enrichie en oxygène.

10. Procédé selon l'une des revendications 2 à 9, **caractérisé en ce qu'**au moins l'étape a) est répétée au moins une fois.

11. Procédé selon l'une des revendications 2 à 10, **caractérisé en ce que** l'étape b) est répétée au moins une fois.

12. Procédé selon l'une des revendications 2 à 11, **caractérisé en ce que** le sel de métal employé dans l'étape a) contient des ions d'argent et/ou d'or et/ou de platine.

13. Procédé selon l'une des revendications 2 à 12, **caractérisé en ce qu'**au moins une solution est additionnée de nanoparticules de métal.

14. Procédé selon la revendication 13, **caractérisé en ce que** les nanoparticules de métal employées sont des nanoparticules d'argent et/ou d'or et/ou de platine.

15. Procédé selon l'une des revendications 2 à 14, **caractérisé en ce qu'**au moins une des solutions est saturée.

16. Procédé selon l'une des revendications 2 à 15, **caractérisé en ce qu'**au moins une autre couche métallique est appliquée.

17. Procédé selon la revendication 16, **caractérisé en ce que** l'autre couche métallique est appliquée de façon galvanique.

18. Procédé selon la revendication 17, **caractérisé en ce que** le dépôt galvanique utilise un électrolyte contenant des ions de cuivre et/ou de métal noble et/ou de nickel et/ou de fer et/ou d'étain et/ou de zinc et/ou de phosphore.

19. Procédé selon l'une des revendications 1 à 18, **caractérisé en ce que** la couche destinée à être supraconductrice à haute température appliquée est un précurseur de HTSL.

20. Procédé selon l'une des revendications 1 à 18, **caractérisé en ce que** la couche destinée à être supraconductrice à haute température est dopée avec de l'O₂ avant l'application de la couche métallique.
